# EUROPÄISCHE PATENTSCHRIFT

(11) **EP 1 825 529 B1**
(45) Veröffentlichungstag und Bekanntmachung des Hinweises auf die Patenterteilung: **16.03.2011**
(21) Anmeldenummer: 05801425.9
(22) Anmeldetag: 20.10.2005
(51) Int. Cl.: H01L 41/04, F02D 41/20, F02D 41/22

(54) **ELEKTRISCHE SCHALTUNG ZUR ANSTEUERUNG EINES PIEZOELEKTRISCHEN ELEMENTS INSBESONDERE EINER KRAFTSTOFFEINSPRITZANLAGE EINES KRAFTFAHRZEUGS**
ELECTRICAL CIRCUIT FOR CONTROLLING A PIEZOELECTRIC ELEMENT, PARTICULARLY OF A FUEL INJECTION SYSTEM OF A MOTOR VEHICLE
CIRCUIT ELECTRIQUE POUR REGULER UN ELEMENT PIEZO-ELECTRIQUE, NOTAMMENT D'UN SYSTEME D'INJECTION DE CARBURANT D'AUTOMOBILE

(30) Priorität: 06.12.2004 DE 102004058671
(43) Veröffentlichungstag der Anmeldung: 29.08.2007
(73) Patentinhaber: ROBERT BOSCH GMBH, 70442 Stuttgart (DE)
(72) Erfinder: GRAF, Marco, 71254 Ditzingen (DE); REINEKE, Joerg, 71254 Ditzingen (DE)
(86) Internationale Anmeldenummer: PCT/EP2005/055424
(87) Internationale Veröffentlichungsnummer: WO 2006/061290

(56) Entgegenhaltungen:
- EP-A- 1 139 442
- DE-A1- 10 033 196
- DE-A1- 19 733 560

## Beschreibung

### Stand der Technik

Die Erfindung geht aus von einer elektrischen Schaltung zur Ansteuerung eines piezoelektrischen Elements insbesondere einer Kraftstoffeinspritzanlage eines Kraftfahrzeugs gemäß dem Oberbegriff des Anspruchs 1. Die Erfindung betrifft ebenfalls ein entsprechendes Verfahren zur Ansteuerung eines piezoelektrischen Elements, sowie ein entsprechendes Computerprogramm, ein entsprechendes elektrisches Speichermedium und ein entsprechendes Steuergerät insbesondere für eine Kraftstoffeinspritzanlage eines Kraftfahrzeugs.

Eine elektrische Schaltung nach dem Oberbegriff des Anspruchs 1 ist aus der EP 1 139 442 A1 bekannt. Dort sind mehrere, aus einem piezoelektrischen Element und einem Transistor bestehende Serienschaltungen zueinander parallel geschaltet. In Serie zu der Parallelschaltung ist ein erster Messwiderstand nach Masse geschaltet. Andererseits ist die Parallelschaltung über eine Drosselspule mit dem gemeinsamen Anschlusspunkt zweier seriell nach Masse geschalteter Transistoren verbunden. Parallel zu den beiden Transistoren ist eine Serienschaltung aus einem Kondensator und einem zweiten Messwiderstand nach Masse geschaltet.

Einer der beiden vorgenannten Transistoren ist zur Entladung der piezoelektrischen Elemente vorgesehen. Hierzu wird dieser Transistor getaktet angesteuert.

Bei einem Fehler ist es erforderlich, dass ein gegebenenfalls aufgeladenes piezoelektrisches Element schnell entladen werden kann. Für diesen Fall ist bei der EP 1 139 442 A1 ein zusätzlicher sogenannter Stop-Schalter vorhanden. Dabei handelt es sich um einen zusätzlichen Transistor und einen zugehörigen Widerstand, über die die piezoelektrischen Elemente im Fehlerfall ungetaktet entladen werden können. Aufgrund der dabei gegebenenfalls fließenden Ströme erfordert die Realisierung dieses Stop-Schalters einen erhöhten Aufwand.

Ferner ist aus der DE 100 33 196A1 ein Verfahren und eine Vorrichtung zur Erkennung eines Fehlerstromes an einem piezoelektrischen Aktor eines Einspritzventils oder an dessen Hochspannung führende Leitung bekannt. Da der Fehlerstrom beispielsweise durch Berührung eines Menschen im Vergleich zum Nutzstrom, der den Aktor auf - oder entlädt, relativ klein ist, ist eine direkte Strommessung nicht zuverlässig. Es wird daher vorgeschlagen, während der Einspritzung bzw. in einer Spritzpause, wenn der piezoelektrische Aktor aufgeladen ist, den Spannungsverlauf oder eine Spannungsänderung zu messen und die Differenz mit einem vorgegebenen Schwellwert zu vergleichen. Bei Überschreiten des Schwellwertes wird eine Fehlermeldung ausgegeben, die Spannungsversorgung abgeschaltet und/oder der piezoelektrische Aktor wird mit Hilfe zweier in Serie angeordneten Halblister schatter entladen.

### Aufgabe und Vorteile der Erfindung

Aufgabe der Erfindung ist es, eine elektrische Schaltung zur Ansteuerung eines piezoelektrischen Elements zu schaffen, mit der im Fehlerfall ein schnelles Entladen der piezoelektrischen Elemente gewährleistet ist, ohne dass hierzu ein besonderer Aufwand erforderlich ist.

Diese Aufgabe wird bei einer elektrischen Schaltung der eingangs genannten Art erfindungsgemäß durch die Merkmale des kennzeichnenden Teils des Anspruchs 1 gelöst. Ebenfalls wird die Aufgabe durch das Verfahren nach dem Anspruch 4 gelöst.

Erfindungsgemäß wird bei einem Fehler der für die Entladung vorgesehene Transistor mit dem vorhandenen Takt angesteuert. Damit ist es möglich, dass der bei der Entladung der piezoelektrischen Elemente fließende Entladestrom ohne größeren Aufwand gesteuert und damit beeinflusst werden kann. Die Entladung kann über den schon vorhandenen, für die Entladung vorgesehen Transistor durchgeführt werden. Ein besonderer Aufwand, insbesondere ein zusätzlicher Transistor für die Entladung der piezoelektrischen Elemente im Fehlerfall ist damit nicht erforderlich.

Die Erfindung ermöglicht damit bei einem Fehler eine schnelle und sichere Entladung der piezoelektrischen Elemente, ohne dass hierzu ein besonderer Aufwand erforderlich ist.

Erfundungsgemäß wird der bei der Entladung fließende Entladestrom gesteuert und/oder geregelt und mit einem in Serie zu den beiden Transistoren geschalteten Messwiderstand ermittelt.

### Ausführungsbeispiele der Erfindung

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.
- Figur 1: zeigt ein schematisches Blockschaltbild einer elektrischen Schaltung zur Ansteuerung von piezoelektrischen Elementen insbesondere einer Kraftstoffeinspritzanlage eines Kraftfahrzeugs,
- Figuren 2a und 2b: zeigen die Schaltung der Figur 1 mit eingezeichneten Stromläufen,
- Figuren 3a und 3b: zeigen schematische Zeitdiagramme von elektrischen Strömen in den Schaltungen der Figuren 2a und 2b, und
- Figur 4 und 5: zeigen schematische Zeitdiagramme eines Ansteuersignals und einer Spannung der Schaltung der Figur 1.

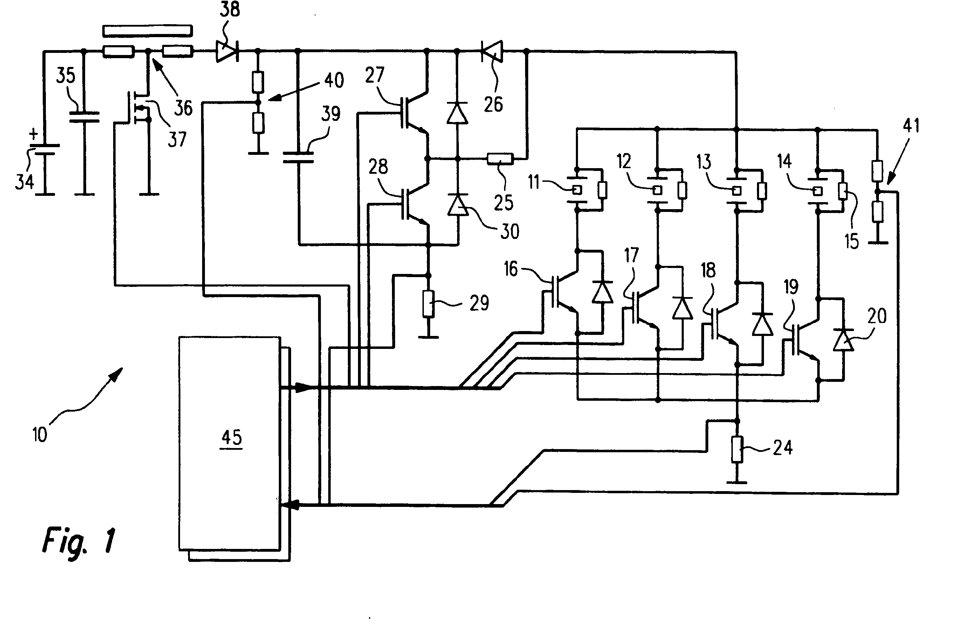

In der Figur 1 ist eine elektrische Schaltung 10 dargestellt, die vier piezoelektrische Elemente 11, 12, 13, 14 aufweist. Es versteht sich, dass auch eine andere Anzahl von piezoelektrischen Elementen vorgesehen sein kann. Die piezoelektrischen Elemente 11, 12, 13, 14 können insbesondere in einer Kraftstoffeinspritzanlage eines Kraftfahrzeugs zur Einspritzung von Kraftstoff verwendet werden.

Jedem der piezoelektrischen Elemente 11, 12, 13, 14 ist ein Widerstand 15 parallel geschaltet. Weiterhin ist zu jedem der piezoelektrischen Elemente 11, 12, 13, 14 ein Transistor 16, 17, 18, 19 in Serie geschaltet. Zu jedem der Transistoren 16, 17, 18, 19 ist eine Freilaufdiode 20 parallel geschaltet.

Die vier piezoelektrischen Elemente 11, 12, 13, 14 sind zueinander parallel geschaltet. Damit sind auch die vier zu den piezoelektrischen Elementen 11, 12, 13, 14 in Serie geschalteten Transistoren 16, 17, 18, 19 zueinander parallel geschaltet. Auf der Seite dieser Transistoren 16, 17, 18, 19 ist die Parallelschaltung mit einem ersten Messwiderstand 24 nach Masse geschaltet.

Der erste Messwiderstand 24 dient der Strommessung. Es versteht sich, dass anstelle des Messwiderstands 24 auch andere Mittel zur Strommessung zur Anwendung kommen können, beispielsweise eine induktive Strommessung.

Auf der anderen Seite, also auf der Seite der piezoelektrischen Elemente 11, 12, 13, 14, ist die Parallelschaltung mit einer Spule 25 und der Anode einer Sicherheitsfreilaufdiode 26 verbunden. Die Kathode der Sicherheitsfreilaufdiode 26 ist über die Serienschaltung zweier Transistoren 27, 28 und eines zweiten Messwiderstands 29 nach Masse geschaltet.

Der zweite Messwiderstand 29 dient der Strommessung.

Zu jedem der beiden Transistoren 27, 28 ist eine Freilaufdiode 30 parallel geschaltet. Der gemeinsame Anschlusspunkt der beiden Transistoren 27, 28 ist mit der Spule 25 verbunden.

Die bisher erläuterte Schaltung 10 wird von einer an Masse liegenden Batterie 34 mit Energie versorgt. Parallel zu der Batterie 34 ist ein Glättungskondensator 35 gegen Masse geschaltet. Der positive Anschluss der Batterie 34 ist mit einem Gleichspannungswandler 36 verbunden, der von einem gegen Masse geschalteten Transistor 37 gesteuert wird. Die der Batterie 34 abgewandte Seite des Gleichspannungswandlers 36 ist mit der Anode einer Diode 38 verbunden, deren Kathode mit der Kathode der Sicherheitsfreilaufdiode 26 zusammengeschaltet ist.

An diesen gemeinsamen Anschlusspunkt der beiden Dioden 26, 38 ist ein Kondensator 39 angeschlossen, der des weiteren mit dem zweiten Messwiderstand 29 verbunden ist. Weiterhin ist an diesen gemeinsamen Anschlusspunkt ein nach Masse geschalteter Spannungsteiler 40 angeschlossen. Ein weiterer Spannungsteiler 41 ist von der Anode der Sicherheitsfreilaufdiode 26 gegen Masse geschaltet.

Die den piezoelektrischen Elementen 11, 12, 13, 14 zugeordneten Transistoren 16, 17, 18, 19, die beiden Transistoren 27, 28, sowie der dem Gleichspannungswandler 36 zugeordnete Transistor 37 sind mit einem sogenannten ASIC 45 (ASIC = application specific integrated circuit) verbunden und werden von diesem gesteuert. Die beiden Messwiderstände 24, 29 sowie die beiden Spannungsteiler 40, 41 sind ebenfalls mit diesem ASIC 45 verbunden und liefern ihre Ströme bzw. Spannungen an denselben.

Die elektrische Schaltung 10 wird damit von dem ASIC 45 angesteuert. Der ASIC 45 wird seinerseits von einem nichtdargestellten Mikroprozessor angesteuert. Der ASIC 45 stellt damit die Schnittstelle zwischen der eine Endstufe bildenden Schaltung 10 und dem Mikroprozessor dar.

Die elektrische Schaltung 10, der ASIC 45 und der Mikroprozessor bilden zusammen ein Steuergerät. Die piezoelektrischen Elemente 11, 12, 13, 14 sind jedoch außerhalb des Steuergeräts und auch außerhalb der elektrischen Schaltung 10 bzw. des vorgenannten ASICs 45 angeordnet und über Anschlussleitungen, beispielsweise einen Kabelbaum, mit der elektrischen Schaltung 10 verbunden.

Das Steuergerät dient zur Steuerung und/oder Regelung der die piezoelektrischen Elemente 11, 12, 13, 14 beaufschlagenden Ströme. Hierzu weist das Steuergerät einen Computer in Form des bereits erwähnten Mikroprozessors mit einem elektrischen Speichermedium auf, insbesondere mit einem Flash-Memory. Auf dem Speichermedium ist ein Computerprogramm abgespeichert, das auf dem Computer ablauffähig ist. Dieses Computerprogramm ist dazu geeignet, die Ströme durch die piezoelektrischen Elemente 11, 12, 13, 14 zu beeinflussen und damit die erwünschte Steuerung und/oder Regelung durchzuführen.

Die Batterie 34 besitzt eine Gleichspannung von beispielsweise 12 Volt oder 24 Volt. Über den Gleichspannungswandler 36 wird diese Gleichspannung auf beispielsweise 240 Volt transformiert. Diese hochgesetzte Gleichspannung liegt an dem Spannungsteiler 40 an, so dass diese Spannung über den Spannungsteiler 40 von dem ASIC 45 ermittelt werden kann. Weiterhin lädt die hochgesetzte Gleichspannung den Kondensator 39 auf. Die an dem Kondensator 39 anliegende Spannung liegt auch an der Serienschaltung der beiden Transistoren 27, 28 an.

Von den beiden Transistoren 27, 28 wird immer nur einer von dem ASIC 45 angesteuert. Weiterhin werden die beiden Transistoren 27, 28, im angesteuerten Fall, getaktet leitend geschaltet. Der hierzu erforderliche Takt wird üblicherweise der elektrischen Schaltung 10 von außen vorgegeben. Der Takt kann gegebenenfalls aber auch von der elektrischen Schaltung 10 selbst erzeugt werden. Bei dem Takt handelt es sich vorzugsweise um ein Rechtecksignal mit aufeinanderfolgenden Einschalt- und Ausschaltzeitdauern. Die Einschalt- und Ausschaltzeitdauern können sich dabei voneinander unterscheiden. Ebenfalls können die Einschalt- und Ausschaltzeitdauern veränderbar sein.

Wird der Transistor 27 leitend geschaltet, so kann eines der piezoelektrischen Elemente 11, 12, 13, 14 aufgeladen werden. Wird hingegen der Transistor 28 leitend geschaltet, so kann ein aufgeladenes piezoelektrisches Element 11, 12, 13, 14 entladen werden. Die an dem jeweiligen piezoelektrischen Element 11, 12, 13, 14 anliegende Spannung kann von dem ASIC 45 mit Hilfe des Spannungsteilers 41 ermittelt werden. Mit Hilfe der Spule 25 wird der Anstieg des beim Aufladen oder Entladen fließenden Stroms begrenzt. Mit Hilfe der Transistoren 16, 17, 18, 19 kann dasjenige piezoelektrische Element 11, 12, 13, 14 von dem ASIC 45 ausgewählt werden, das aufgeladen werden soll.

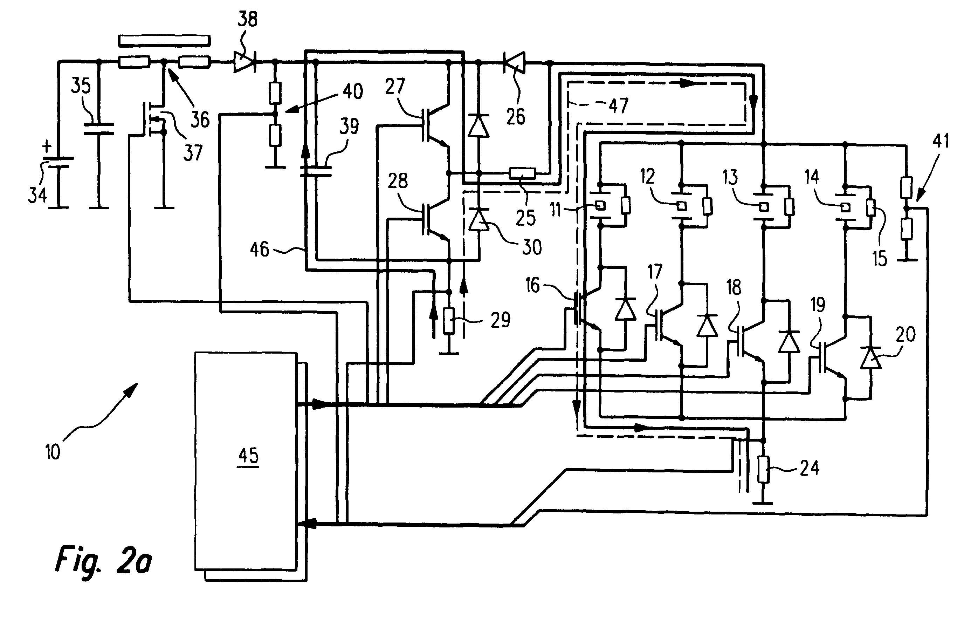

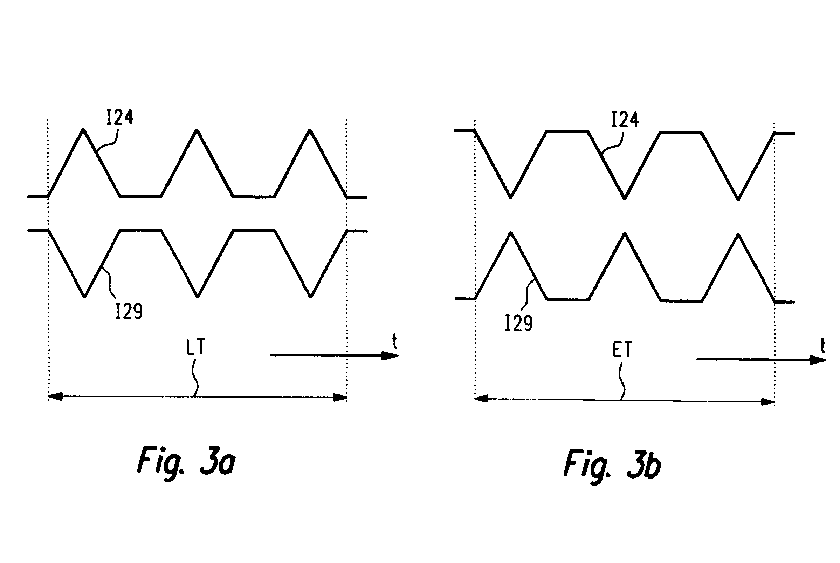

Das Aufladen eines der piezoelektrischen Elemente 11, 12, 13, 14 wird nachfolgend anhand der Figuren 2a, 3a erläutert.

Soll beispielsweise das piezoelektrische Element 11 aufgeladen werden, so werden die Transistoren 16, 27 von dem ASIC 45 zuerst leitend geschaltet. Es fließt ein Strom von dem Kondensator 39, über den leitend geschalteten Transistor 27, über die Spule 25, über das piezoelektrische Element 11, über den leitend geschalteten Transistor 16, über den ersten Messwiderstand 24, über Masse und über den zweiten Messwiderstand 29 zurück zu dem Kondensator 39. Dieser Stromlauf ist in der Figur 2a als durchgezogene Linie 46 eingezeichnet.

Danach wird der Transistor 27 gesperrt. Es fließt ein Strom von der Spule 25 über das piezoelektrische Element 11, über den leitend geschalteten Transistor 16, über den ersten Messwiderstand 24, über Masse, über den zweiten Messwiderstand 29, über die untere der beiden Freilaufdioden 30 zurück zu der Spule 25. Dieser Stromlauf ist in der Figur 2a als gestrichelte Linie 47 eingezeichnet.

Danach wird der Transistor 27 wieder leitend geschaltet, so dass wieder ein Strom gemäß dem Stromlauf 46 fließt. Dieses Takten des Transistors 27 wird fortgesetzt, bis das piezoelektrische Element 11 auf eine erwünschte Spannung aufgeladen ist.

In der Figur 3a sind die über die beiden Messwiderstände 24, 29 fließenden Ströme über der Zeit t aufgetragen. Es handelt sich dabei um den im oberen Diagramm gezeigten Strom I24 über den Messwiderstand 24 und über den im unteren Diagramm gezeigten Strom I29 über den Messwiderstand 29. Weiterhin ist in der Figur 3a die Aufladezeitdauer LT eingetragen, während der der Transistor 27 getaktet wird, um das piezoelektrische Element 11 in der erwünschten Weise aufzuladen.

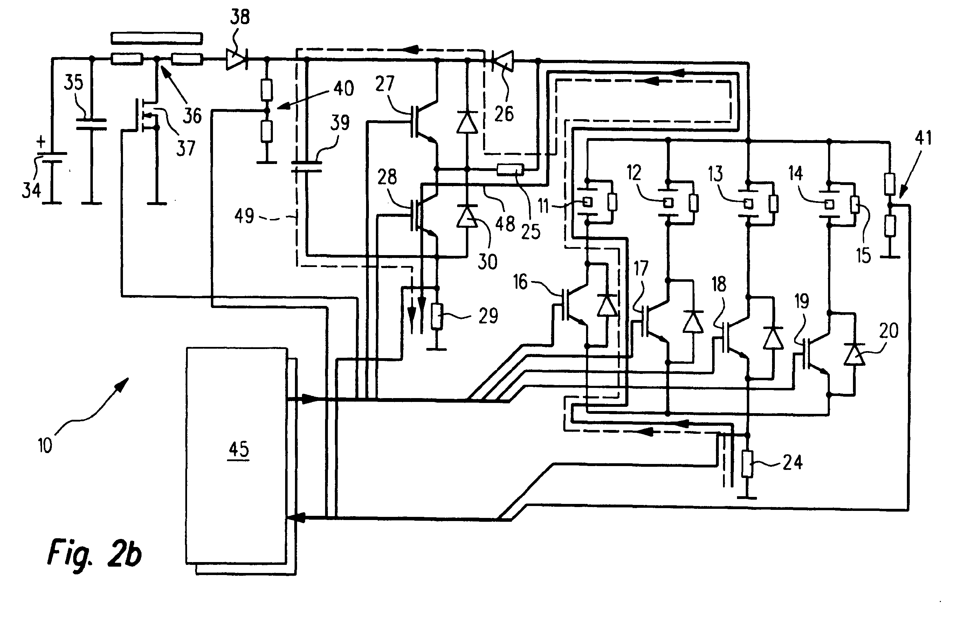

Das Entladen eines der piezoelektrischen Elemente 11, 12, 13, 14 entspricht grundsätzlich dem erläuterten Laden eines der piezoelektrischen Elemente 11, 12, 13, 14, wobei sich insbesondere die Stromrichtung ändert. Dieses Entladen wird nachfolgend anhand der Figuren 2b, 3b erläutert.

Soll beispielsweise das piezoelektrische Element 11 entladen werden, so wird der Transistor 28 und der Transistor 16 von dem ASIC 45 zuerst leitend geschaltet. Es fließt ein Strom mit einem Stromlauf, wie er in der Figur 2b als durchgezogene Linie 48 eingezeichnet ist. Danach wird der Transistor 28 gesperrt. Es fließt ein Strom mit einem Stromlauf, wie er in der Figur 2b als gestrichelte Linie 49 eingezeichnet. Danach wird der Transistor 28 wieder leitend geschaltet, so dass wieder ein Strom gemäß dem Stromlauf 48 fließt. Dieses Takten des Transistors 28 wird fortgesetzt, bis das piezoelektrische Element 11 in der erwünschten Weise entladen ist.

In der Figur 3b sind die über die beiden Messwiderstände 24, 29 fließenden Ströme über der Zeit t aufgetragen. Es handelt sich dabei um den im oberen Diagramm gezeigten Strom I24 über den Messwiderstand 24 und über den im unteren Diagramm gezeigten Strom I29 über den Messwiderstand 29. Weiterhin ist in der Figur 3b die Entladezeitdauer ET eingetragen, während der der Transistor 28 getaktet wird, um das piezoelektrische Element 11 in der erwünschten Weise zu entladen.

Unter anderem mit Hilfe der beiden Messwiderstände 24, 29 sowie der über diese Messwiderstände 24, 29 fließenden Ströme I24, I29 ist es möglich, Fehler der elektrischen Schaltung 10 oder der piezoelektrischen Elemente 11, 12, 13, 14 zu erkennen. Insbesondere kann von dem Steuergerät erkannt werden, ob bzw. dass ein Anschluss eines der piezoelektrischen Elemente 11, 12, 13, 14 gegen Masse oder zu der von der Batterie 34 gelieferten Gleichspannung kurzgeschlossen ist.

Bei Fehlerfällen, beispielsweise bei einem Kurzschluss eines piezoelektrischen Elements 11, 12, 13, 14 gegen Masse oder zu der von der Batterie 34 gelieferten Gleichspannung, besteht die Möglichkeit, dass eines der piezoelektrischen Elemente 11, 12, 13, 14 im Zeitpunkt der Fehlererkennung gerade aufgeladen oder zumindest teilweise aufgeladen ist. Zum Schutz des jeweiligen piezoelektrischen Elements 11, 12, 13, 14 ist es dann erforderlich, dass dieses piezoelektrische Element 11, 12, 13, 14 wieder entladen und die elektrische Schaltung 10 in einen sicheren Betriebszustand übergeführt wird.

Wird von dem Steuergerät ein derartiger Fehler erkannt, so wird eine gesteuerte und/oder geregelte Entladung der piezoelektrischen Elemente 11, 12, 13, 14 durch das Steuergerät durchgeführt.

Bei diesem Entladevorgang wird der Strom I29 über den Messwiderstand 29 ermittelt. Dieser Strom I29 ist auch dann vorhanden, wenn ein Kurzschluss eines Anschlusses eines der piezoelektrischen Elemente 11, 12, 13, 14 gegen Masse oder gegen die von der Batterie 34 gelieferte Gleichspannung vorliegt. Der Strom I24 über den Messwiderstand 24 ist jedoch in den vorgenannten Fehlerfällen zumindest nicht sicher vorhanden.

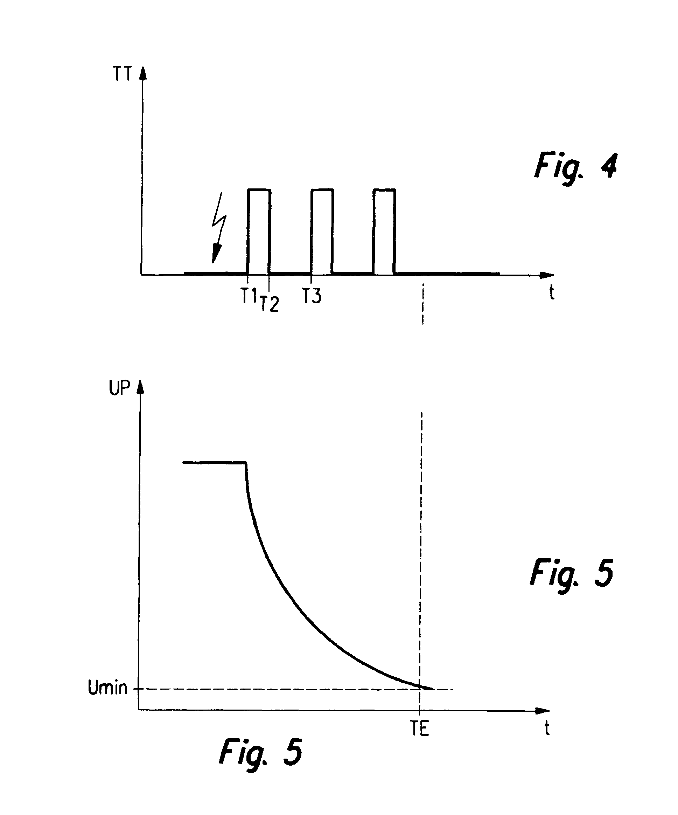

In Abhängigkeit von dem Strom I29 über den Messwiderstand 29 wird dann von dem ASIC 45 die Entladung der piezoelektrischen Elemente 11, 12, 13, 14, insbesondere der dabei fließende Entladestrom, gesteuert und/oder geregelt. Dies wird nachfolgend anhand der Figuren 4 und 5 erläutert.

In der Figur 4 ist der Takt TT, mit dem der Transistor 28 angesteuert wird, über der Zeit t aufgetragen. In der Figur 5 ist die an zumindest einem der piezoelektrischen Elemente 11, 12, 13, 14 anliegende Spannung UP über der Zeit t aufgetragen. Dies ist gleichbedeutend damit, dass eines der piezoelektrischen Elemente 11, 12, 13, 14 in diesem Zeitpunkt aufgeladen oder zumindest teilweise aufgeladen ist.

Zum Entladen wird der Transistor 28 zuerst in einem Zeitpunkt T1 geschlossen. Es fließt dann ein Entladestrom von den piezoelektrischen Elementen 11, 12, 13, 14 über die Spule 25, über den Transistor 28 und über den Messwiderstand 29 nach Masse. Die Spannung UP an den piezoelektrischen Elementen 11, 12, 13, 14 sinkt mit der Zeit ab. Dies geht aus Figur 5 hervor. Mit Hilfe des Messwiderstands 29 wird der Entladestrom gemessen. Erreicht der Entladestrom einen vorgegebenen oberen Grenzwert, so wird der Transistor 28 geöffnet. Dies ist in der Figur 4 als Zeitpunkt T2 gekennzeichnet.

Danach fließt der Entladestrom von den piezoelektrischen Elementen 11, 12, 13, 14 über die Spule 25, über den Kondensator 39 und über den Messwiderstand 29 nach Masse. Die an den piezoelektrischen Elementen 11, 12, 13, 14 anliegende Spannung UP fällt weiter ab. Nach einer vorgegebenen Zeitdauer oder nachdem der vorgenannte Strom einen unteren Grenzwert erreicht hat, wird der Transistor 28 in einem Zeitpunkt T3 wieder geschlossen. Der Entladestrom fließt wieder über den Transistor 28 und steigt mit der Zeit an.

Durch das beschriebene Ein- und Ausschalten des Transistors 28 wird das entsprechende piezoelektrische Elemente 11, 12, 13, 14 entladen. Wie erläutert wurde, wird das Ein- und Ausschalten des Transistors 28 in Abhängigkeit von dem über den Messwiderstand 29 fließenden Entladestrom durchgeführt. Das Ein- und Ausschalten des Transistors 28 wird beendet, sobald die Spannung UP an den piezoelektrischen Elementen 11, 12, 13, 14 einen vorgegebenen Wert Umin unterschreitet. Dies ist in einem Zeitpunkt TE der Figur 5 der Fall. Die Spannung UP kann dabei mit Hilfe des Spannungsteilers 41 ermittelt werden. Es wird dann davon ausgegangen, dass das entsprechende piezoelektrische Element 11, 12, 13, 14 entladen ist oder dessen Spannung zumindest nicht größer als die von der Batterie 34 gelieferte Gleichspannung ist.

Falls durch einen Kurzschluss gegen die von der Batterie 34 gelieferte Gleichspannung die Schwelle Umin nicht erreicht werden kann, wird das Entladen nach einer fest vorgegebenen Zeitdauer beendet.

Die elektrische Schaltung 10 und die piezoelektrischen Elemente 11, 12, 13, 14 weisen damit einen sicheren, insbesondere entladenen Betriebszustand auf. Der bei der Entladung fließende Entladestrom entspricht dabei im wesentlichen demjenigen Strom, der im Normalbetrieb der elektrischen Schaltung 10 ebenfalls fließt. Gegebenenfalls können die im Zusammenhang mit den Figuren 4 und 5 erläuterten Grenzwerte und Zeitdauern unabhängig von dem Normalbetrieb vorgegeben und damit an den speziellen Fall einer Entladung im Fehlerfall angepasst werden.

## Patentansprüche

1. Elektrische Schaltung (10) zur Ansteuerung eines piezoelektrischen Elements (11, 12, 13, 14) insbesondere einer Kraftstoffeinspritzanlage eines Kraftfahrzeugs, mit zwei in Serie geschalteten, mit einem Takt (TT) ansteuerbaren Transistoren (27, 28), deren gemeinsamer Anschlusspunkt mit dem piezoelektrischen Element (11, 12, 13, 14) gekoppelt ist, und von denen einer (28) zur Entladung des piezoelektrischen Elements (11, 12, 13, 14) vorgesehen ist, **dadurch gekennzeichnet, dass** bei einem Fehler der für die Entladung vorgesehene Transistor (28) mit dem Takt (TT) ansteuerbar ist, wobei der zur Entladung fließende Entladestrom steuer- und/oder regelbar is und ein Messwiderstands (29) zur Ermittlung des Entladestroms vorgesehen ist, wobei der Messwiderstand (29) in Serie zu den beiden Transistoren (27, 28) geschaltet ist.

2. Elektrische Schaltung (10) nach Anspruch 1, **dadurch gekennzeichnet, dass** der bei der Entladung fließende Entladestrom ermittelbar ist, und dass dieser Entladestrom in Abhängigkeit davon regelbar ist.

3. Elektrische Schaltung (10) nach Anspruch 2, **dadurch gekennzeichnet, dass** der Entladestrom derart regelbar ist, dass der Entladestrom einen oberen Grenzwert nicht überschreitet.

4. Verfahren zur Ansteuerung eines piezoelektrischen Elements (11, 12, 13, 14) insbesondere einer Kraftstoffeinspritzanlage eines Kraftfahrzeugs, bei dem zwei in Serie geschaltete Transistoren (27, 28), deren gemeinsamer Anschlusspunkt mit dem piezoelektrischen Element (11, 12, 13, 14) gekoppelt ist und von denen einer (28) zur Entladung des piezoelektrischen Elements (11, 12, 13, 14) vorgesehen ist, mit einem Takt (TT) angesteuert werden, **dadurch gekennzeichnet, dass** bei einem Fehler der für die Entladung vorgesehene Transistor (28) mit dem Takt (TT) angesteuert wird, wobei der bei der Entladung fließende Entladestrom gesteuert und/oder geregelt wird, und mit einem in Serie zu den beiden Transistoren (27, 28) geschalteten Messwiderstand (29) ermittelt wird.

5. Computerprogramm, **dadurch gekennzeichnet, dass** es zur Anwendung in einem Verfahren nach Anspruch 4 programmiert ist.

6. Elektrisches Speichermedium für ein Steuergerät, **dadurch gekennzeichnet, dass** auf ihm ein Computerprogramm abgespeichert ist, das zur Anwendung in einem Verfahren nach Anspruch 4 programmiert ist.

7. Steuergerät insbesondere für eine Kraftstoffeinspritzanlage eines Kraftfahrzeugs, **dadurch gekennzeichnet, dass** es zur Anwendung in einem Verfahren nach Anspruch 4 hergerichtet ist.

## Claims

1. Electrical circuit (10) for controlling a piezoelectric element (11, 12, 13, 14), particularly of a fuel injection system of a motor vehicle, having two transistors (27, 28) which are connected in series, can be controlled with a clock pulse (TT) and whose common connecting point is coupled to the piezoelectric element (11, 12, 13, 14) and one (28) of which transistors is provided for discharging the piezoelectric element (11, 12, 13, 14), **characterized in that** in the event of a fault the transistor (28) which is provided for discharging can be controlled with the clock pulse (TT), wherein the discharge current which flows for the purpose of discharging can be open-loop and/or closed-loop controlled, and a measuring resistor (29) is provided for determining the discharge current, wherein the measuring resistor (29) is connected in series with the two transistors (27, 28).

2. Electrical circuit (10) according to Claim 1, **characterized in that** the discharge current which flows during discharging can be determined, and **in that** this discharge current can be closed-loop controlled as a function thereof.

3. Electrical circuit (10) according to Claim 2, **characterized in that** the discharge current can be closed-loop controlled in such a way that the discharge current does not exceed an upper limiting value.

4. Method for controlling a piezoelectric element (11, 12, 13, 14), particularly of a fuel injection system of a motor vehicle, in which two transistors (27, 28) which are connected in series and whose common connecting point is coupled to the piezoelectric element (11, 12, 13, 14) and one (28) of which transistors is provided for discharging the piezoelectric element (11, 12, 13, 14), are controlled with a clock pulse (TT), **characterized in that** in the event of a fault the transistor (28) which is provided for discharging is controlled with the clock pulse (TT), wherein the discharge current which flows during discharging is open-loop and/or closed-loop controlled, and is determined by means of a measuring resistor (29) which is connected in series with the two transistors (27, 28).

5. Computer program, **characterized in that** it is programmed for use in a method according to Claim 4.

6. Electrical storage medium for a control unit, **characterized in that** a computer program which is programmed for use in a method according to Claim 4 is stored thereon.

7. Control unit, in particular for a fuel injection system of a motor vehicle, **characterized in that** said control unit is designed for use in a method according to Claim 4.

## Revendications

1. Circuit électrique (10) pour commander un élément piézoélectrique (11, 12, 13, 14), notamment une installation d'injection de carburant d'un véhicule automobile, comprenant deux transistors (27, 28) montés en série et pouvant être commandés par une horloge (TT), dont le point de raccordement commun est accouplé à l'élément piézoélectrique (11, 12, 13, 14), et dont l'un (28) est prévu pour décharger l'élément piézoélectrique (11, 12, 13, 14), **caractérisé en ce que**, dans le cas d'une erreur, le transistor (28) prévu pour la décharge peut être commandé avec l'horloge (TT), le courant de décharge circulant en vue de la décharge pouvant être commandé et/ou réglé et une résistance de mesure (29) étant prévue pour déterminer le courant de décharge, la résistance de mesure (29) étant montée en série avec les deux transistors (27, 28).

2. Circuit électrique (10) selon la revendication 1, **caractérisé en ce que** le courant de décharge circulant lors de la décharge peut être déterminé, et **en ce que** ce courant de décharge peut être réglé en conséquence.

3. Circuit électrique (10) selon la revendication 2, **caractérisé en ce que** le courant de décharge peut être réglé de telle sorte que le courant de décharge ne dépasse pas une valeur limite supérieure.

4. Procédé de commande d'un élément piézoélectrique (11, 12, 13, 14), notamment d'une installation d'injection de carburant d'un véhicule automobile, dans lequel deux transistors (27, 28) montés en série, dont le point de raccordement commun est accouplé à l'élément piézoélectrique (11, 12, 13, 14) et dont l'un (28) est prévu pour décharger l'élément piézoélectrique (11, 12, 13, 14), sont commandés par une horloge (TT), **caractérisé en ce que**, dans le cas d'une erreur, le transistor (28) prévu pour la décharge est commandé avec l'horloge (TT), le courant de décharge circulant lors de la décharge étant commandé et/ou réglé, et étant déterminé avec une résistance de mesure (29) montée en série avec les deux transistors (27, 28).

5. Programme informatique, **caractérisé en ce qu'**il est programmé pour être utilisé dans un procédé selon la revendication 4.

6. Support de mémoire électrique pour un appareil de commande, **caractérisé en ce qu'**un programme informatique est stocké sur celui-ci, lequel est programmé pour être utilisé dans un procédé selon la revendication 4.

7. Appareil de commande, en particulier pour une installation d'injection de carburant d'un véhicule automobile, **caractérisé en ce qu'**il est prévu pour être utilisé dans un procédé selon la revendication 4.
